# EUROPÄISCHE PATENTSCHRIFT

(11) **EP 1 421 617 B1**
(45) Veröffentlichungstag und Bekanntmachung des Hinweises auf die Patenterteilung: **09.11.2005**
(21) Anmeldenummer: 02798677.7
(22) Anmeldetag: 29.08.2002
(51) Int. Cl.: H01L 23/373

(54) **LEISTUNGSELEKTRONIKEINHEIT**
POWER ELECTRONICS COMPONENT
UNITE ELECTRONIQUE DE PUISSANCE

(30) Priorität: 31.08.2001 DE 10142614
(43) Veröffentlichungstag der Anmeldung: 26.05.2004
(73) Patentinhaber: SIEMENS AKTIENGESELLSCHAFT, 80333 München (DE)
(72) Erfinder: LUCKE, Olaf, 60598 Frankfurt/Main (DE); THYZEL, Bernd, 61479 Schlossborn (DE)
(86) Internationale Anmeldenummer: PCT/DE2002/003177
(87) Internationale Veröffentlichungsnummer: WO 2003/026008

(56) Entgegenhaltungen:
- DE-A- 4 100 145
- DE-A- 19 740 330
- DE-A- 19 807 718
- DE-A- 19 810 544
- DE-C- 3 831 148
- US-A- 5 159 532

## Beschreibung

Die Erfindung bezieht sich auf eine Leistungselektronikeinheit, insbesondere für ein Steuergerät in einem Kraftfahrzeug, mit einem Trägerelement, auf dem Leiterbahnen zur elektrischen Verbindung von ebenfalls auf dem Trägerelement befindlichen elektrischen Leistungsbauelementen und Steuerbauelementen einer Schaltung angeordnet sind, wobei das Trägerelement wärmeleitend mit einem wärmeleitenden Gehäusebauteil eines das Trägerelement aufnehmenden Gehäuses verbunden ist.

DE-A-19 807 718 offenbart eine solche Leistungselektronikeinheit.

Bei Leistungselektronikeinheiten besteht das Problem, daß die elektrischen Leistungsbauelemente Wärme erzeugen, die abgeführt werden muß. Dazu ist es bekannt das Trägerelement als isolierende Leiterplatte auszubilden, auf der Kupferleiterbahnen z.B. durch Kaschieren aufgebracht sind und die elektrischen Leistungsbaüelemente und ggf. auch Steuerbauelemente durch Löten mit den Kupferleiterbahnen verbunden sind. Mittels Wärmeleitkleber sind diese Leiterplatten auf die Gehäusebauteile aufgeklebt, wobei das Gehäusebauteil damit sowohl als Wärmespreizer dient, als auch die Wärme an die Umgebung abgibt.

DE-A-4 100 145 und DE-A-19 740 330 behandeln das problem der Wärme abfuhr von Bauteilen auf Keramik Korpern.

Dabei ist von Nachteil, daß der Wärmewiderstand zwischen den elektrischen Leistungsbauelementen und dem Gehäusebauteil relativ groß und insbesondere bei einer größeren Dichte von elektrischen Leistungsbauelementen auf der Leiterplatte die Wärmeabfuhr ungenügend ist.

Aufgabe der Erfindung ist es daher, eine Leistungselektronikeinheit der eingangs genannten Art zu schaffen, bei der bei einfachem Aufbau trotz elektrischer Isolation der elektrischen Leistungsbauelemente ein geringer Wärmewiderstand zwischen den elektrischen Leistungsbauelementen und dem Gehäusebauteil vorhanden ist.

Diese Aufgabe wird erfindungsgemäß dadurch gelöst, daß das Trägerelement aus einem porösen, keramischen Bauteil besteht, dessen Poren mit Metall oder mit Metallen gefüllt sind und das mit einem Dickschicht-Dielektrikum bedeckt ist, auf dem die Leiterbahnen als Dickschichtleiterbahnen und die Leistungsbauelemente aufgebracht und die Leiterbahnen durch Löten mit den elektrischen Leistungsbauelementen elektrisch leitend verbunden sind, wobei das Trägerelement an dem Gehäusebauteil anliegend angeordnet ist.

Ein derartig ausgebildetes metallisches Trägerelement hat den Vorteil, daß es durch die sehr gute Wärmeleitfähigkeit bereits als Wärmespreizer dient und sehr unmittelbar die von den elektrischen Leistungsbauelementen erzeugte Wärme auf eine große Fläche verteilt. Gleichzeitig verhindert aber der geringe Ausdehnungskoeffizient bei den hohen TemperaturWechselbeanspruchungen, denen die Leistungselektronikeinheit insbesondere in einem Kraftfahrzeug unterworfen ist, ein Abreißen der elektrischen Leistungsbauelemente von den Leiterbahnen. Von der bereits großen Fläche des Trägerelements kann dann eine gute Wärmeabfuhr zum üblicher Weise aus Aluminium bestehenden Gehäusebauteil und von dort an die Umgebung erfolgen.

Die elektrische Isolation erfolgt über das Dickschicht-Dielektrikum, das sehr dünn ausgebildet sein kann und den guten Wärmeübergang von den elektrischen Leistungsbauelementen zum Trägerelement nur unwesentlich beeinflußt, aufgrund des dehnungsangepaßten Schichtensystems aber eine sichere Verbindung der darauf aufgebrachten Dickschichtleiterbahnen sicher stellt.

Durch die gute Wärmeableitung lassen sich kleinere und damit preiswertere und geringeren Bauraum erfordernde elektrische Leistungsbauelemente einsetzen.

Bevorzugte Ausbildungen des Trägerelements bestehen darin, daß das Trägerelement aus einer Siliziumcarbidmatrix besteht, deren Poren mit Aluminium gefüllt sind oder daß das Trägerelement aus einer gesinterten Kupfermatrix besteht, deren Poren mit Molybdän gefüllt sind oder daß das Trägerelement aus einer gesinterten Kupfermatrix besteht, deren Poren mit Wolfram gefüllt sind. Diese Ausbildungen verbinden die Vorteile der gute Wärmeleitfähigkeit mit Ausdehnungskoeffizienten, die weit unter denen von Kupfer oder Aluminium liegen und etwa gleich denen der elektrischen Leistungsbauelemente sind.

Ist das Trägerelement eine Trägerplatte mit einer Dicke größer 0,5 mm, insbesondere einer Dicke zwischen etwa 0,5 mm und 4,0 mm, so ist das separat mit Schaltung und elektrischen Leistungsbauelementen fertig herstellbare Bauteil als stabiles, bruchsicheres Bauteil einfach an dem Gehäusebauteil anordenbar.

Das Dickschicht-Dielektrikum kann eine Glasschicht sein, die in einfacher Weise auf das Trägerelement aufgedruckt und durch einen Temperaturprozeß an das Trägerelement angebunden sein kann.

Eine andere Möglichkeit besteht darin, daß das Dickschicht-Dielektrikum eine Plasmaschicht ist, die vorzugsweise eine in einem Plasmasprühprozeß aufgebrachte Al₂O₃ - Schicht ist. Dabei kann das Dickschicht-Dielektrikum eine Dicke zwischen etwa 5 µm und 40 µm aufweisen und somit.den Wärmedurchgang weitestgehend unbeeinflußt lassen.

Es besteht aber auch die Möglichkeit, zunächst eine Plasmaschicht auf das Trägerelement und auf die Plasmaschicht die Glasschicht aufzubringen, wodurch die elektrische Isolierung besonders sicher ist und die Plasmaschicht als Haftvermittler der Glasschicht dient.

Zur Vereinfachung des Herstellungsprozesses können die Leiterbahnen auf einer LTTC-Folie (low temperatur fired ceramic) aufgedruckt auf das Dickschicht-Dielektrikum aufgebracht und durch einen Temperaturprozeß an das Dickschicht-Dielektrikum angebunden sein.

Dabei kann die LTTC-Folie eine Dicke von etwa 0,1 mm aufweisen. Eine besondere Reduzierung des Herstellungsaufwandes ergibt sich, wenn Dickschicht-Dielektrikum und mit den Leiterbahnen versehene LTTC-Folie nach ihrem Aufbringen auf das Trägerelement in einem gemeinsamen Temperaturprozeß temperaturbeaufschlagt sind, da damit die Anzahl der Temperaturprozesse reduziert werden kann.

Zur sicheren Verbindung der elektrischen Leistungsbauelemente dient es, wenn die Leiterbahnen Anschlußpads zur Verbindung der elektrischen Leistungsbauelemente und/oder der Steuerbauelemente aufweisen.

Ist das Trägerelement flächig an dem Gehäusebauteil anliegend angeordnet, so wird eine besonders gute Abfuhr der von den elektrischen Leistungsbauelementen erzeugten Wärme erreicht.

Eine sowohl sichere als auch einfach durchzuführende Anordnung des Trägerelements am Gehäusebauteil wird dadurch erreicht, daß das Trägerelement mittels Befestigungselementen an dem Gehäusebauteil angeordnet ist, wobei in einfacher Weise das Trägerelement mittels Schrauben an dem Gehäusebauteil befestigt ist und somit die Verbindung beliebig fest ausgelegt werden kann.

Zusätzlich kann zwischen Trägerelement und Gehäusebauteil eine Schicht Wärmeleitpaste angeordnet sein. Um eine besonders gute Wärmeabfuhr an die Umgebung zu erreichen, kann das Gehäusebauteil eine Außenwand des Gehäuses sein.

Ist die von den elektrischen Leistungsbauelementen erzeugte und abzuführende Wärme besonders hoch, so kann das Gehäusebauteil eine von einem Kühlmittel beaufschlagbare Wand des Gehäuses sein.

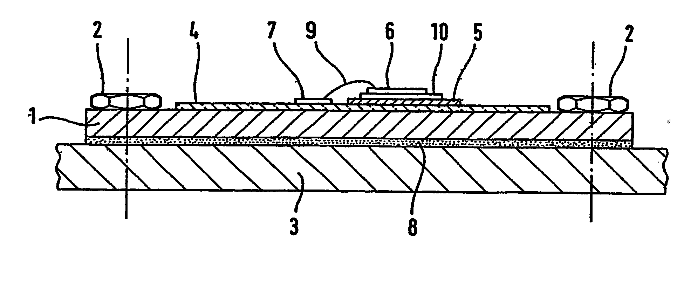

Ein Ausführungsbeispiel der Erfindung ist in der Zeichnung dargestellt und wird im folgenden näher beschrieben. Die einzige Figur der Zeichnung zeigt eine Leistungselektronikeinheit im Querschnitt.

Die dargestellte Leistungselektronikeinheit besitzt eine Trägerplatte 1, die aus einer Siliziumcarbidmatrix besteht, deren Poren mit Aluminium gefüllt sind (Al-SiC). Diese Trägerplatte 1, die eine Dicke von 1,5 mm aufweist, ist mittels Schrauben auf einer Außenwand 3 eines Gehäuses aus Aluminium flächig aufliegend befestigt, wobei zwischen der Trägerplatte 1 und der Außenwand 3 des Gehäuses eine dünne Schicht Wärmeleitpaste 8 angeordnet ist.

Auf der der Außenwand 3 abgewandten Seite ist auf der Trägerplatte 1 eine Glasschicht 4 (Al₂O₃) aufgedruckt.

Darauf wurde eine LTTC-Folie aufgebracht, auf der das Muster der Leiterbahnen 5 einer Schaltung in Dickschichttechnik aufgedruckt waren.

In einem anschließenden Temperaturprozeß wurden die Glasschicht 4 und die Leiterbahnen 5 fest mit der Trägerplatte 1 verbunden.

Neben der Leiterbahn 5 wurde auf der Glasschicht 4 ein elektrisches Leistungsbauelement 7 (Leistungshalbleiterelement) aufgebracht und der Anschluß 9 des Leistungsbauelements 7 durch Löten mittels Weichlot 6 elektrisch leitend mit einem Anschlußpad 10 der Leiterbahn 5 verbunden.

## Patentansprüche

1. Leistungselektronikeinheit, insbesondere für ein Steuergerät in einem Kraftfahrzeug, mit einem Trägerelement, auf dem Leiterbahnen zur elektrischen Verbindung von ebenfalls auf dem Trägerelement befindlichen elektrischen Leistungsbauelementen und Steuerbauelementen einer Schaltung angeordnet sind, wobei das Trägerelement wärmeleitend mit einem wärmeleitenden Gehäusebauteil eines das Trägerelement aufnehmenden Gehäuses verbunden ist und das Trägerelement an dem Gehäusebauteil anliegend angeordnet ist, **dadurch gekennzeichnet, daß** das Trägerelement aus einem porösen, keramischen Bauteil besteht, dessen Poren mit Metall oder mit Metallen gefüllt sind und das mit einem Dickschicht-Dielektrikum bedeckt ist, auf dem die Leiterbahnen (5) als Dickschichtleiterbahnen und die Leistungsbauelemente (7) aufgebracht und die Leiterbahnen (5) durch Löten mit den elektrischen Leistungsbauelementen (7) elektrisch leitend verbunden sind.

2. Leistungselektronikeinheit nach Anspruch 1, **dadurch gekennzeichnet, daß** das Trägerelement aus einer Siliziumcarbidmatrix besteht, deren Poren mit Aluminium gefüllt sind.

3. Leistungselektronikeinheit nach Anspruch 1, **dadurch gekennzeichnet, daß** das Trägerelement aus einer gesinterten Kupfermatrix besteht, deren Poren mit Molybdän gefüllt sind.

4. Leistungselektronikeinheit nach Anspruch 1, **dadurch gekennzeichnet, daß** das Trägerelement aus einer gesinterten Kupfermatrix besteht, deren Poren mit Wolfram gefüllt sind.

5. Leistungselektronikeinheit nach einem der vorhergehenden Ansprüche, **dadurch gekennzeichnet, daß** das Trägerelement eine Trägerplatte (1) mit einer Dicke größer 0,5 mm ist.

6. Leistungselektronik nach Anspruch 5, **dadurch gekennzeichnet, daß** die Trägerplatte (1) eine Dicke zwischen etwa 0,5 mm und 4,0 mm aufweist.

7. Leistungselektronik nach einem der vorhergehenden Ansprüche, **dadurch gekennzeichnet, daß** das Dickschicht-Dielektrikum eine Glasschicht (4) ist.

8. Leistungselektronik nach Anspruch 7, **dadurch gekennzeichnet, daß** die Glasschicht (4) auf das Trägerelement aufgedruckt und durch einen Temperaturprozeß an das Trägerelement angebunden ist.

9. Leistungselektronikeinheit nach einem der vorhergehenden Ansprüche, **dadurch gekennzeichnet, daß** das Dickschicht-Dielektrikum eine Plasmaschicht ist.

10. Leistungselektronikeinheit nach Anspruch 9, **dadurch gekennzeichnet, daß** die Plasmaschicht eine in einem Plasmasprühprozeß aufgebrachte Al₂O₃ - Schicht ist.

11. Leistungselektronikeinheit nach einem der Ansprüche 7 bis 10, **dadurch gekennzeichnet, daß** das Dickschicht-Dielektrikum eine Dicke zwischen etwa 5 µm und 40 µm aufweist.

12. Leistungselektronikeinheit nach einem der vorhergehenden Ansprüche, **dadurch gekennzeichnet, daß** die Leiterbahnen (5) auf einer LTTC-Folie aufgedruckt auf das Dickschicht-Dielektrikum aufgebracht und durch einen Temperaturprozeß an das Dickschicht-Dielektrikum angebunden sind.

13. Leistungselektronikeinheit nach Anspruch 12, **dadurch gekennzeichnet, daß** die LTTC-Folie eine Dicke von etwa 0,1 mm aufweist.

14. Leistungselektronikeinheit nach einem der vorhergehenden Ansprüche, **dadurch gekennzeichnet, daß** Dickschicht-Dielektrikum und mit den Leiterbahnen versehene LTTC-Folie nach ihrem Aufbringen auf das Trägerelement in einem gemeinsamen Temperaturprozeß temperaturbeaufschlagt sind.

15. Leistungselektronikeinheit nach einem der vorhergehenden Ansprüche, **dadurch gekennzeichnet, daß** die Leiterbahnen (5) Anschlußpads (10) zur Verbindung der elektrischen Leistungsbauelemente (7) und/oder der Steuerbauelemente aufweisen.

16. Leistungselektronik nach einem der vorhergehenden Ansprüche, **dadurch gekennzeichnet, daß** das Trägerelement flächig an dem Gehäuseteil anliegend angeordnet ist.

17. Leistungselektronikeinheit nach einem der vorhergehenden Ansprüche, **dadurch gekennzeichnet, daß** das Trägerelement mittels Befestigungselementen an dem Gehäuseteil angeordnet ist.

18. Leistungselektronikeinheit nach Anspruch 17, **dadurch gekennzeichnet, daß** das Trägerelement mittels Schrauben (2) an dem Gehäuseteil befestigt ist.

19. Leistungselektronikeinheit nach einem der vorhergehenden Ansprüche, **dadurch gekennzeichnet, daß** zwischen Trägerelement und Gehäuseteil eine Schicht Wärmeleitpaste (8) angeordnet ist.

20. Leistungselektronikeinheit nach einem der vorhergehenden Ansprüche, **dadurch gekennzeichnet, daß** das Gehäuseteil eine Außenwand (3) des Gehäuses ist.

21. Leistungselektronikeinheit nach einem der vorhergehenden Ansprüche, **dadurch gekennzeichnet, daß** das Gehäuseteil eine von einem Kühlmittel beaufschlagbare Wand des Gehäuses ist.

## Claims

1. Power electronics unit, in particular for a control device in a motor vehicle, with a support element on which conductor tracks are arranged for electrically connecting electrical power components and control components of a circuit that are likewise arranged on the support element, the support element being connected in a thermally conducting manner to a thermally conducting housing component of a housing accommodating the support element and the support element being arranged such that it rests against the housing component, **characterized in that** the support element comprises a porous, ceramic component, the pores of which are filled with metal or with metals and which is covered with a thick-film dielectric, on which the conductor tracks (5) as thick-film conductor tracks and the power components (7) are provided and the conductor tracks (5) are connected to the electrical power components (7) in an electrically conducting manner by soldering.

2. Power electronics unit according to Claim 1, **characterized in that** the support element comprises a silicon carbide matrix, the pores of which are filled with aluminium.

3. Power electronics unit according to Claim 1, **characterized in that** the support element comprises a sintered copper matrix, the pores of which are filled with molybdenum.

4. Power electronics unit according to Claim 1, **characterized in that** the support element comprises a sintered copper matrix, the pores of which are filled with tungsten.

5. Power electronics unit according to one of the preceding claims, **characterized in that** the support element is a support plate (1) with a thickness of greater than 0.5 mm.

6. Power electronics unit according to Claim 5, **characterized in that** the support plate (1) has a thickness of between approximately 0.5 mm and 4.0 mm.

7. Power electronics unit according to one of the preceding claims, **characterized in that** the thick-film dielectric is a glass layer (4).

8. Power electronics unit according to Claim 7, **characterized in that** the glass layer (4) is printed onto the support element and bonded to the support element by a thermal process.

9. Power electronics unit according to one of the preceding claims, **characterized in that** the thick-film dielectric is a plasma layer.

10. Power electronics unit according to Claim 9, **characterized in that** the plasma layer is an Al₂O₃ layer applied in a plasma spraying process.

11. Power electronics unit according to one of Claims 7 to 10, **characterized in that** the thick-film dielectric has a thickness of between approximately 5 µm and 40 µm.

12. Power electronics unit according to one of the preceding claims, **characterized in that** the conductor tracks (5) are printed on an LTTC sheet and in this form applied to the thick-film dielectric and bonded to the thick-film dielectric by a thermal process.

13. Power electronics unit according to Claim 12, **characterized in that** the LTTC sheet has a thickness of approximately 0.1 mm.

14. Power electronics unit according to one of the preceding claims, **characterized in that**, after they have been applied to the support element, the thick-film dielectric and the LTTC sheet provided with the conductor tracks are exposed to temperature in a joint thermal process.

15. Power electronics unit according to one of the preceding claims, **characterized in that** the conductor tracks (5) have terminal pads (10) for connecting the electrical power components (7) and/or the control components.

16. Power electronics unit according to one of the preceding claims, **characterized in that** the support element is arranged such that it is resting flat against the housing component.

17. Power electronics unit according to one of the preceding claims, **characterized in that** the support element is arranged on the housing component by means of fastening elements.

18. Power electronics unit according to Claim 17, **characterized in that** the support element is fastened on the housing component by means of screws (2).

19. Power electronics unit according to one of the preceding claims, **characterized in that** a layer of thermally conductive paste (8) is arranged between the support element and the housing component.

20. Power electronics unit according to one of the preceding claims, **characterized in that** the housing component is an outer wall (3) of the housing.

21. Power electronics unit according to one of the preceding claims, **characterized in that** the housing component is a wall of the housing that can be subjected to a cooling agent.

## Revendications

1. Unité électronique de puissance destinée, notamment, à un appareil de commande dans un véhicule automobile et comportant un élément support sur lequel sont disposées des pistes conductives destinées au raccordement électrique de composants électriques de puissance et de composants de commande d'un circuit se trouvant également sur l'élément support, où l'élément support est lié en conduction thermique à un constituant thermoconducteur d'un boîtier renfermant l'élément support et où l'élément support est monté accolé au constituant du boîtier, **caractérisée par le fait que** l'élément support se compose d'un constituant poreux en céramique, dont les pores sont remplis de métal ou de métaux et qui est recouvert d'un diélectrique en couche épaisse sur lequel sont apportées les pistes conductives (5), en tant que pistes conductives en couche épaisse, et les composants de puissance (7) et les pistes conductives (5) sont reliées électriquement par soudure aux composants électriques de puissance (7).

2. Unité électronique de puissance selon la revendication 1 **caractérisée par le fait que** l'élément support est composé d'une matrice en carbure de silicium dont les pores sont remplis d'aluminium.

3. Unité électronique de puissance selon la revendication 1 **caractérisée par le fait que** l'élément support est composé d'une matrice en cuivre frittée dont les pores sont remplis de molybdène.

4. Unité électronique de puissance selon la revendication 1 **caractérisée par le fait que** l'élément support est composé d'une matrice en cuivre frittée dont les pores sont remplis de tungstène.

5. Unité électronique de puissance selon l'une des revendications précédentes **caractérisée par le fait que** l'élément support est une plaque support (1) ayant une épaisseur supérieure à 0,5 mm.

6. Unité électronique de puissance selon la revendication 5 **caractérisée par le fait que** la plaque support (1) a une épaisseur comprise entre environ 0,5 mm et 4,0 mm.

7. Unité électronique de puissance selon l'une des revendications précédentes **caractérisée par le fait que** le diélectrique en couche épaisse est une couche de verre (4).

8. Unité électronique de puissance selon la revendication 7 **caractérisée par le fait que** la couche de verre (4) est imprimée sur l'élément support et est liée à l'élément support grâce à un traitement thermique.

9. Unité électronique de puissance selon l'une des revendications précédentes **caractérisée par le fait que** le diélectrique en couche épaisse est une couche de plasma.

10. Unité électronique de puissance selon la revendication 9 **caractérisée par le fait que** la couche de plasma est une couche de Al₂O₃ appliquée au cours d'un processus de pulvérisation de plasma.

11. Unité électronique de puissance selon l'une des revendications 7 à 10 **caractérisée par le fait que** le diélectrique en couche épaisse a une épaisseur comprise entre 5 µm et 40 µm.

12. Unité électronique de puissance selon l'une des revendications précédentes **caractérisée par le fait que** les pistes conductives (5) sont appliquées sur le diélectrique en couche épaisse imprimées sur une membrane en LTTC et liées au diélectrique en couche épaisse grâce à un traitement thermique.

13. Unité électronique de puissance selon la revendication 12 **caractérisée par le fait que** la membrane en LTTC a une épaisseur d'environ 0,1 mm.

14. Unité électronique de puissance selon l'une des revendications précédentes **caractérisée par le fait que** le diélectrique en couche épaisse et la membrane en LTTC munie des pistes conductives sont soumis, après leur application sur l'élément support, à un traitement thermique commun.

15. Unité électronique de puissance selon l'une des revendications précédentes **caractérisée par le fait que** les pistes conductives (5) ont des pôles de raccordement (10) destinés à la connexion des composants électriques de puissance (7) et / ou des composants de commande.

16. Unité électronique de puissance selon l'une des revendications précédentes **caractérisée par le fait que** l'élément support est monté accolé en nappe sur le constituant du boîtier.

17. Unité électronique de puissance selon l'une des revendications précédentes **caractérisée par le fait que** l'élément support est monté sur le constituant du boîtier à l'aide de moyens de fixation.

18. Unité électronique de puissance selon la revendication 17 **caractérisée par le fait que** l'élément support est fixé au constituant de boîtier au moyen de vis (2).

19. Unité électronique de puissance selon l'une des revendications précédentes **caractérisée par le fait qu'**une couche de pâte thermoconductrice (8) est placée entre l'élément support et la pièce du boîtier.

20. Unité électronique de puissance selon l'une des revendications précédentes **caractérisée par le fait que** la pièce du boîtier est une paroi extérieure (3) du boîtier.

21. Unité électronique de puissance selon l'une des revendications précédentes **caractérisée par le fait que** la pièce du boîtier est une paroi du boîtier soumise à un produit réfrigérant.
